# EUROPÄISCHE PATENTSCHRIFT

(11) **EP 4 484 967 B1**
(45) Veröffentlichungstag und Bekanntmachung des Hinweises auf die Patenterteilung: **10.09.2025**
(21) Anmeldenummer: 23181529.1
(22) Anmeldetag: 26.06.2023
(51) Int. Cl.: G01R 15/06, G01R 15/16, G01R 19/145

(54) **KAPAZITIVE SPANNUNGSPRÜFVORRICHTUNG**
CAPACITIVE VOLTAGE TESTING DEVICE
DISPOSITIF DE TEST DE TENSION CAPACITIF

(43) Veröffentlichungstag der Anmeldung: 01.01.2025
(73) Patentinhaber: Kries Ingenieurbüro GmbH & Co. KG, 71334 Waiblingen (DE)
(72) Erfinder: Kries, Gunter, 71384 Weinstadt (DE)
(74) Vertreter: Patentanwälte Ruff, Wilhelm, Beier, Dauster & Partner mbB

(56) Entgegenhaltungen:
- DE-B3- 102020 214 614
- DE-U1- 202010 016 782
- US-A- 4 446 421

## Beschreibung

Die Erfindung bezieht sich auf eine kapazitive Spannungsprüfvorrichtung mit einem kapazitiven Spannungsteiler, der einen Primärkondensator zur messstellenseitigen Ankopplung an eine zu messende Spannung und einen Sekundärkondensator zur auswerteseitigen Ankopplung an ein Bezugspotential umfasst, und mit einer Auswerteeinheit, die einen an einen Mittelabgriff des kapazitiven Spannungsteilers angekoppelten Messsignaleingang aufweist. Die kapazitive Spannungsprüfvorrichtung ist insbesondere zur elektrischen Spannungsprüfung in Niederspannungsanlagen geeignet. Mit den Begriffen messstellenseitig und auswerteseitig ist vorliegend eine einer Messstelle, an der die zu messende Spannung abgegriffen bzw. angelegt wird, zugewandte Seite bzw. eine der Auswerteeinheit zugewandte Seite der betreffenden Komponente, wie dem Primärkondensator, gemeint. Bei dem Bezugspaotential kann es sich insbesondere um ein Erdpotential handeln.

Kapazitive Spannungsprüfvorrichtungen dieser Art werden in vielerlei Ausführungen angepasst an den jeweiligen Anwendungsfall für die Spannungsprüfung in elektrischen Stromversorgungsnetzen und speziell in Niederspannungs-, Mittelspannungs- und Hochspannungsanlagen wie Niederspannungs-, Mittelspannungs- und Hochspannungs-Verteilnetzen verwendet. Eine solche Spannungsprüfung ist dort typischerweise schon aus Personenschutzgründen vorgeschrieben. Der Primärkondensator wird in diesen Anwendungen auch als Primärkapazität oder kapazitive Koppelelektrode bezeichnet und ist in Mittelspannungs- und Hochspannungs-Verteilnetzen typischerweise als entsprechendes block- bzw. zylinderförmiges Isolierbauteil mit integriertem Kondensator bereits am Messort in zugeordneten Isolationskomponenten, wie Durchführungen oder Teilerstützer, vorintegriert oder lässt sich dort problemlos nachrüsten bzw. anordnen.

Verschiedene derartige kapazitive Spannungsprüfvorrichtungen für diese Anwendungen befinden sich unter der Modellreihenbezeichnung CAP-Line mit CAPDIS-Prüfgerät und zugehörigen kapazitiven Koppelelektroden von der Kries-Energietechnik GmbH & Co. KG auf dem Markt.

In der Norm IEC 62271-213 sind derartige kapazitive Spannungsprüfvorrichtungen für Mittelspannungsanlagen beschrieben und hinsichtlich ihrer notwendigen Eigenschaften festgelegt.

Die Patentschrift DE 10 2020 214 614 B3 offenbart eine spezielle Schaltungsanordnung zur Spannungsprüfung in Mittel- und Hochspannungsanlagen, die u.a. eine derartige kapazitive Spannungsprüfvorrichtung umfasst.

Die Patentschrift DE 10 2021 201 465 B4 offenbart eine Schaltungsanordnung zur Spannungsprüfung und Teilentlladungserfassung in einer ein- oder mehrphasigen Mittel- oder Hochspannungsanlage, wobei dort an die vorhandene kapazitive Koppelelektrode ein Innenleiter, i.e. die Kabelseele, einer einadrigen Koaxialleitung, die als Prüfverbindungsleitung zwischen Messstellenseite und Auswerteseite fungiert, ankoppelbar ist und zur Teilentlladungserfassung ein hochfrequentes Teilentladungssignal von einer Erdungsseite einer zur kapazitiven Koppelelektrode elektrisch parallelen Anlagesystemkapazität, zu der z.B. Feldsteuerbeläge von Hochspannungskabelsteckern und Schirmmäntel von Hochspannungskabeln beitragen, auskoppelbar und einer Teilentladungsdetektoreinheit zuführbar ist.

In Niederspannungsanlagen liegen im Vergleich zu Mittel- und Hochspannungsanlagen oftmals relativ beengte Platzverhältnisse vor, was es schwierig macht, am Messort kapazitive Koppelelektroden wie im Fall von Mittel- und Hochspannungsanlagen als eigenständige block- bzw. zylinderförmige Kondensatorbauteile vorzuintegrieren oder anzuordnen. Einer Verlegung des Primärkondensators in das räumlich entfernte Auswertegerät würde an der Auskoppelstelle ein Sicherungselement gegen Kurzschluss in der nachfolgenden Verbindungsleitung erfordern, was u.a. wegen des erhöhten Aufwands unvorteilhaft ist. Denn für alle galvanischen Verbindungsleitungen ist in solchen Anlagen eine Absicherung an der Ankoppelstelle vorzusehen, wenn ein Kurzschluss in den Verbindungsleitungen einen Schaden der vorgelagerten Gesamtanlage zur Folge haben könnte.

Der Erfindung liegt als technisches Problem die Bereitstellung einer kapazitiven Spannungsprüfvorrichtung der eingangs genannten Art zugrunde, die gegenüber dem oben erwähnten Stand der Technik weitergehend verbessert ist und insbesondere eine vorteilhafte kapazitive Spannungsprüfung auch unter relativ beengten Platzverhältnissen mit relativ geringem Aufwand ermöglicht, wie sie typisch in Niederspannungsanlagen vorliegen.

Die Erfindung löst dieses Problem durch die Bereitstellung einer kapazitiven Spannungsprüfvorrichtung mit den Merkmalen des Anspruchs 1. Vorteilhafte Weiterbildungen der Erfindung sind Gegenstand der Unteransprüche, deren Wortlaut hiermit durch Verweis zum Bestandteil der Beschreibung gemacht wird. Dies schließt insbesondere auch alle Ausführungsformen der Erfindung ein, die sich aus den Merkmalskombinationen ergeben, die durch die Rückbezüge in den Unteransprüchen definiert sind.

Die erfindungsgemäße kapazitive Spannungsprüfvorrichtung beinhaltet eine mehradrige Prüfverbindungsleitung mit einer ersten Leitungsader und einer gegenüber der ersten Leitungsader elektrisch isolierten zweiten Leitungsader, die zusammen den Primärkondensator bilden, wobei eine der beiden Leitungsadern messstellenseitig einen Messspannungsanschluss und auswerteseitig einen isolierten Anschluss aufweist und die andere Leitungsader messstellenseitig einen isolierten Anschluss und auswerteseitig einen Mittelabgriffanschluss aufweist.

Erfindungsgemäß wird folglich der Primärkondensator durch die mehradrige Prüfverbindungsleitung bereitgestellt, welche als Verbindung zwischen der Messstelle, d.h. dem Ort, an dem die zu messende Spannung abgegriffen bzw. angelegt wird, und der Auswerteeinheit bzw. einem Messgerät fungiert, in welchem sich die Auswerteeinheit befindet. Der Kondensator besteht hierbei aus den beiden jeweils an einem Ende isoliert endenden Leitungsadern als Kondensatorelektroden und der zwischenliegenden Isolation als Kondensatordieelektrikum. Dazu verlaufen die beiden Leitungsadern elektrisch voneinander isoliert, d.h. galvanisch voneinander getrennt.

Es ist daher erfindungsgemäß nicht erforderlich, als Primärkondensator ein eigenständiges, typischerweise block- oder zylinderförmiges bzw. diskretes Kondensatorbauteil einzusetzen, so dass dementsprechend auch keine Vorinstallation bzw.

Vorintegration eines solchen Kondensatorbauteils und auch kein Platzbedarf zum Anordnen eines solchen Kondensatorbauteils erforderlich ist. Die Prüfverbindungsleitung besitzt je nach Anwendungsfall eine Länge typisch zwischen einigen Zentimetern bis zu wenigen Metern. Die Prüfverbindungsleitung stellt eine galvanische Trennung mit hinreichend großer Spannungsfestigkeit zwischen der Auskoppelstelle, d.h. der Messstelle, und der Auswerteeinheit, d.h. der Auswerteseite, sowie in mehrphasigen Anwendungen auch zwischen den Phasen dar, so dass an der Auskoppelstelle keine Vorsicherung benötigt wird.

Dadurch eignet sich die erfindungsgemäße kapazitive Spannungsprüfvorrichtung besonders auch für Spannungsprüfungen an Einsatzstellen mit relativ beengten Platzverhältnissen und damit insbesondere zur Spannungsprüfung in Niederspannungsanlagen, bei denen in aller Regel nur wenig Raum für die Spannungsprüfung zur Verfügung steht. Unabhängig davon versteht es sich, dass die erfindungsgemäße kapazitive Spannungsprüfvorrichtung auch für andere Anwendungen geeignet ist, bei denen nicht das Problem enger Platzverhältnisse besteht. Insbesondere eignet sich die erfindungsgemäße kapazitive Spannungsprüfvorrichtung für alle Anwendungen, bei denen messstellenseitig kein Primärkondensator vorinstalliert oder in anderer Weise bereitgestellt ist. Erfindungsgemäß ist der Primärkondensator in die Prüfverbindungsleitung integriert, die ohnehin zur Ankopplung der Auswerteeinheit bzw. eines entsprechenden Messgerätes an die Messstelle mit der zu messenden Spannung benötigt wird. Dazu bedarf es lediglich der mehradrigen Ausführung der Prüfverbindungsleitung in der erwähnten Weise mit den mindestens zwei kondensatorbildend realisierten Leitungsadern.

Zudem ermöglicht die erfindungsgemäße kapazitive Spannungsprüfvorrichtung eine sehr einfache Kontaktierung mit der zu messenden Spannung, üblicherweise auch als Primärspannung bezeichnet. Hierfür braucht lediglich die zugeordnete Leitungsader der Prüfverbindungsleitung mit ihrem Messspannungsanschluss an die Primärspannung bzw. an einen von der Primärspannung beaufschlagten Spannungsanschluss angekoppelt werden, z.B. an eine entsprechende Niederspannungsklemme in einer Niederspannungsanlage.

In einer Weiterbildung der Erfindung sind die beiden Leitungsadern von nebeneinander in einer gemeinsamen Kabelleitung verlaufenden Linienleitern oder von einer Kabelseele und einem Kabelschirm einer Koaxialleitung gebildet. Dies stellt vorteilhafte alternative Ausführungen zur Bildung des Primärkondensators durch die beiden Leitungsadern dar.

Wie daran erkennbar, ist vorliegend der Begriff Leitungsader in einem weiten Sinn zu verstehen, der allgemein einen hohlen oder massiven, linienförmig verlaufenden elektrischen Leiter umfasst. Dabei können die beiden Leitungsadern kondensatorbildend nebeneinander oder wie im Fall einer Koaxialleitung als Kabelseele und Kabelschirm kondensatorbildend ineinander angeordnet sein, d.h. im letztgenannten Fall verläuft die eine Leitungsader im Inneren der sie umgebenden, hohlen anderen Leitungsader. Beide alternative Ausführungen eignen sich gut zur Bereitstellung des Primärkondensators mit einer Kapazität von z.B. typisch zwischen 10 pF und mehr als einigen Hundert pF, wie für den Einsatzzweck bei der Spannungsprüfung in Niederspannungsanlagen mit typischen Primärspannungen bis höchstens ca. 1000 V oder 2000 V üblicherweise gefordert. Typische Kapazitäten des Sekundärkondensators liegen in diesem Fall in der Größenordnung von einigen nF.

In einer Weiterbildung der Erfindung weist die Prüfverbindungsleitung eine die beiden Leitungsadern umgebende und geerdete Schirmleitung auf. Die Schirmleitung kann die beiden Leitungsadern gegen etwaige unerwünschte Wechselwirkungen, in mehrphasigen Anwendungen insbesondere auch gegen kapazitive Einkopplungen aus den Nachbarphasen, bzw. Interferenzen elektromagnetischer Art mit Komponenten außerhalb der Prüfverbindungsleitung abschirmen.

In einer Ausgestaltung der Erfindung weist die Auswerteeinheit einen Spannungskomparator auf, und die Schirmleitung weist messstellenseitig einen Erdungsanschluss auf und ist auswerteseitig mit dem Spannungskomparator verbindbar, wobei die Auswerteeinheit zur Leiterbruchüberwachung anhand eines Spannungsvergleichssignals des Spannungskomparators eingerichtet ist. In dieser Ausführung eignet sich folglich die erfindungsgemäße kapazitive Spannungsprüfvorrichtung vorteilhaft zusätzlich zur Leiterbruchüberwachung, wozu die Schirmleitung messstellenseitig geerdet, d.h. mit ihrem Erdungsanschluss an ein Erdpotential angekoppelt wird. Das vom Spannungskomparator gelieferte Spannungsvergleichssignal ändert sich, wenn bei der Prüfverbindungsleitung oder zumindest bei der Schirmleitung ein Leiterbruch auftritt, da dann die Schirmleitung das messstellenseitige Erdpotential nicht mehr zur Auswerteeinheit bzw. zu deren Spannungskomparator durchleitet. Die Schirmleitung fungiert folglich in diesem Fall als eine zur Leiterbruchüberwachung dienende weitere Leitungsader der Prüfverbindungsleitung.

In einer Ausgestaltung der Erfindung weist die Auswerteeinheit eine Teilentladungserkennungseinheit auf, und die Schirmleitung weist messstellenseitig einen Erdungsanschluss auf und ist mit ihrem Erdungsanschluss über ein Tiefpassfilter an ein Erdpotential ankoppelbar und auswerteseitig mit der Teilentladungserkennungseinheit verbindbar. Damit eignet sich die kapazitive Spannungsprüfvorrichtung in vorteilhafter Weise zusätzlich zur Teilentladungserkennung. Die Schirmleitung stellt hierbei eine weitere kapazitive Koppelung zur potentialführenden Leitungsader dar und erlaubt damit eine hochfrequente Auskoppelung von Teilentladungen. Damit diese nicht gegen Erde kurzgeschlossen werden, wird in diesem Fall auf der Primärseite das Tiefpassfilter vorgesehen, das Frequenzen kleiner z.B. 1 kHz und damit alle betriebsfrequenten Signale niederohmig gegen Erde ableitet, während hochfrequente Signale auf der Schirmleitung verbleiben und auf der Auswerteseite der Teilentladungserkennungsschaltung der Auswerteeinheit zugeführt werden können. Die gemeinsame oder phasenselektive Auswertung der aus den drei Phasen eines dreiphasigen Systems ausgekoppelten Teilentladungen erfolgt in diesem Fall in der Auswerteeinheit und dient dem Benutzer zur Erkennung, ob im Niederspannungssystem eine Teilentladung und folglich ein Isolationsverlust vorliegt.

In einer Weiterbildung der Erfindung ist die kapazitive Spannungsprüfvorrichtung zur dreiphasigen Spannungsprüfung eingerichtet ist und umfasst für jede Phase je einen kapazitiven Spannungsteiler, der einen zugehörigen Primärkondensator zur messstellenseitigen Ankopplung an eine zu messende Spannung der Phase und einen Sekundärkondensator zur auswerteseitigen Ankopplung an ein Bezugspotential, und je eine mehradrige Prüfverbindungsleitung mit einer ersten Leitungsader und einer gegenüber der ersten Leitungsader elektrisch isolierten zweiten Leitungsader aufweist, die zusammen den zugehörigen Primärkondensator bilden. Dabei beinhaltet die Auswerteeinheit für jede Phase je einen Messsignaleingang, der an einen Mittelabgriff des zugehörigen kapazitiven Spannungsteilers angekoppelt ist.

In dieser Ausführung eignet sich die erfindungsgemäße kapazitive Spannungsprüfvorrichtung vorteilhaft zur dreiphasigen Spannungsprüfung, wozu sie für jede Phase den oben für den einphasigen Anwendungsfall erläuterten, erfindungsgemäßen Aufbau mit jeweiligem kapazitivem Spannungsteiler und jeweiliger primärkondensatorbildender mehradriger Prüfverbindungsleitung aufweist. Es versteht sich, dass je nach Bedarf die der jeweiligen Phase zugeordneten mehradrigen Prüfverbindungsleitungen als einzelne Verbindungsleitungen oder als integrale Bestandteile einer einzigen, einheitlichen mehradrigen Verbindungsleitung oder zu einem gemeinsamen Verbindungskabel zusammengefasst sein können. Analog kann die Auswerteeinheit je nach Bedarf und Anwendungsfall durch eine einzige Auswerteeinheit bzw. ein einziges Messgerät oder durch mehrere einzelne, je einer Phase zugeordnete Auswerteeinheiten bzw. Messgeräte realisiert sein.

In einer Ausgestaltung der Erfindung weisen die mehradrigen Prüfverbindungsleitungen separat voneinander je eine ihre beiden Leitungsadern umgebende und geerdete Schirmleitung auf. Dadurch kann zuverlässig ein kapazitives Übersprechen zwischen den Phasen bzw. den Prüfverbindungsleitungen vermieden werden.

Eine vorteilhafte Ausführungsform der Erfindung ist in den Zeichnungen dargestellt. Diese und weitere Ausführungsformen der Erfindung werden nachfolgend näher beschrieben. Hierbei zeigt die einzige
- Figur: eine schematische Blockdiagrammdarstellung einer kapazitiven Spannungsprüfvorrichtung in einer dreiphasigen Ausführung.

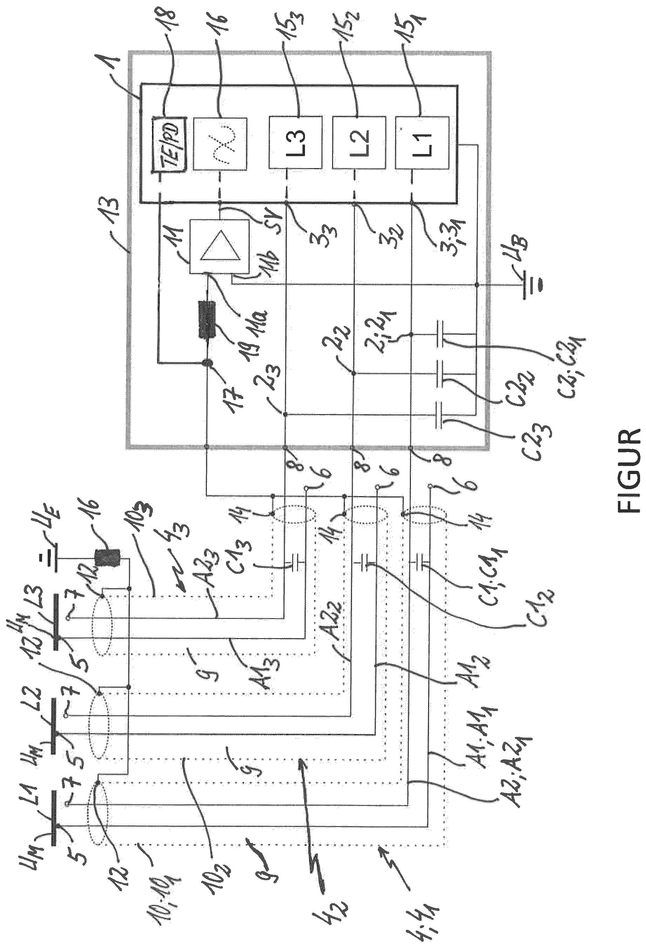

Wie in der Figur blockdiagrammatisch veranschaulicht, beinhaltet die erfindungsgemäße kapazitive Spannungsprüfvorrichtung einen kapazitiven Spannungsteiler, der einen Primärkondensator C1 zur messstellenseitigen Ankopplung an eine zu messende Spannung U_{M} und einen Sekundärkondensator C2 zur auswerteseitigen Ankopplung an ein Bezugspotential U_{B} umfasst, sowie eine Auswerteeinheit 1 mit einem an einen Mittelabgriff 2 des kapazitiven Spannungsteilers angekoppelten Messsignaleingang 3. Des Weiteren beinhaltet die kapazitive Spannungsprüfvorrichtung eine mehradrige Prüfverbindungsleitung 4 mit einer ersten Leitungsader A1 und einer gegenüber der ersten Leitungsader A1 elektrisch isolierten zweiten Leitungsader A2, die zusammen den Primärkondensator C1 bilden. Je nach Bedarf und Anwendungsfall weist die Prüfverbindungsleitung 4 eine oder mehrere weitere Leitungsadern auf, die vorliegend nicht weiter interessieren. Der kapazitive Spannungsteiler wandelt die höhere, zu messende Spannung, z.B. eine Niederspannung im Bereich bis höchstens ca. 1000 V oder 2000 V, in eine niedrigere Auswertespannung, z.B. eine Kleinspannung im Bereich bis höchstens ca. 48 V.

Eine der beiden Leitungsadern A1, A2, im gezeigten Beispiel die Leitungsader A1, weist messstellenseitig einen Messspannungsanschluss 5 und auswerteseitig einen isolierten Anschluss 6 auf, während die andere Leitungsader, im gezeigten Beispiel die Leitungsader A2, messstellenseitig einen isolierten Anschluss 7 und auswerteseitig einen Mittelabgriffanschluss 8 aufweist.

In entsprechenden Ausführungen der Spannungsprüfvorrichtung sind die beiden Leitungsadern A1, A2, wie im gezeigten Beispiel, von nebeneinander in einer gemeinsamen Kabelleitung 9 verlaufenden Linienleitern gebildet. In alternativen, nicht gezeigten Ausführungen sind die beiden Leitungsadern A1, A2 von koaxialen Leitern gebildet, wie einem Hohlleiter und einem von diesem umgebenen Linienleiter, beispielsweise von einem Kabelschirm und einer Kabelseele einer Koaxialleitung, d.h. in letzterem Fall ist die Prüfverbindungsleitung als Koaxialleitung ausgeführt.

In vorteilhaften Ausführungen weist die Prüfverbindungsleitung, wie im gezeigten Beispiel, eine die beiden Leitungsadern A1, A2 umgebende und geerdete Schirmleitung 10 auf. Es versteht sich, dass alle drei Leitungsadern, d.h. die erste Leitungsader A1, die zweite Leitungsader A2 und die Schirmleitung 10 als dritte Leitungsader durch zwischenliegendes Isolationsmaterial voneinander elektrisch isoliert sind.

In vorteilhaften Ausführungsformen mit der Schirmleitung 10 weist die Auswerteeinheit 1 einen Spannungskomparator 11 auf, und die Schirmleitung 10 beinhaltet messstellenseitig einen Erdungsanschluss 12 zum Ankoppeln an ein Erdpotential U_{E} und ist auswerteseitig mit dem Spannungskomparator 11 verbindbar. Die Auswerteeinheit 1 ist zur Leiterbruchüberwachung anhand eines Spannungsvergleichssignals SV des Spannungskomparators 11 eingerichtet.

Diese Ausführung ermöglicht folglich zusätzlich zur eigentlichen Spannungsprüffunktionalität eine Leiterbruchüberwachung, durch welche die Auswerteeinheit 1 einen Leiterbruch der Prüfverbindungsleitung 4 oder zumindest der Schirmleitung 10 erkennen kann. Dazu ist die Schirmleitung 10 messstellenseitig mit ihrem Erdungsanschluss 12 geerdet, d.h. an das Erdpotential U_{E} angekoppelt. Wenn durch einen Leiterbruch die Schirmleitung 10 unterbrochen ist, kann sie das Erdpotential U_{E} nicht mehr zum Spannungskomparator 11 durchleiten, wodurch sich das vom Spannungskomparator 11 gelieferte Spannungsvergleichssignal SV ändert, was von der Auswerteeinheit 1 erkannt wird. Im gezeigten Beispiel ist hierzu die Schirmleitung 10 an einem auswerteseitigen Ende bzw. Anschluss 14 mit einem ersten Eingang 11a des Spannungskomparators 11 verbunden, während der Spannungskomparator 11 mit einem zweiten Eingang 11b an ein auswerteseitiges Erdpotential angekoppelt ist, wie an das Bezugspotential U_{B}, an das auch der Sekundärkondensator C2 angekoppelt ist.

Während die kapazitive Spannungsprüfvorrichtung vorstehend für den einphasigen Fall in einer entsprechenden Mindestausführung erläutert wurde, ist sie in vorteilhaften Ausführungsformen zur mehrphasigen Spannungsprüfung und insbesondere, wie im gezeigten Beispiel, zur dreiphasigen Spannungsprüfung eingerichtet und beinhaltet für jede Phase L1, L2, L3 je einen kapazitiven Spannungsteiler und je eine mehradrige Prüfverbindungsleitung 4₁, 4₂, 4₃.

Jeder kapazitive Spannungsteiler umfasst einen zugehörigen Primärkondensator C1₁, C1₂, C1₃ entsprechend dem oben erwähnten Primärkondensator C1 im einphasigen Fall, wobei der jeweilige Primärkondensator C1₁, C1₂, C1₃ an eine zu messende Spannung U_{M1}, U_{M2}, U_{M3} der betreffenden Phase ankoppelbar ist. Des Weiteren umfasst der jeweilige kapazitive Spannungsteiler einen zugehörigen Sekundärkondensator C2₁, C2₂, C2₃, entsprechend dem oben erwähnten Sekundärkondensator C2 im einphasigen Fall, zur auswerteseitigen Ankopplung an ein jeweiliges, vorzugsweise gleiches Bezugspotential U_{B}. Jede der drei mehradrigen Prüfverbindungsleitungen 4₁, 4₂, 4₃ weist entsprechend der oben für den einphasigen Fall erwähnten Prüfverbindungsleitung 4 je eine erste Leitungsader A1₁, A1₂, A1₃ und je eine gegenüber dieser elektrisch isolierte zweite Leitungsader A2₁, A2₂, A2₃ auf, die zusammen den zugehörigen Primärkondensator C1₁, C1₂, C1₃ bilden.

Die Auswerteeinheit 1 beinhaltet für jede Phase je einen Messsignaleingang 3₁, 3₂, 3₃ entsprechend dem oben erwähnten Messsignaleingang 3 im einphasigen Fall, wobei der jeweilige Messignaleingang 3₁, 3₂, 3₃ an einen zugehörigen Mittelabgriff 2₁, 2₂, 2₃ des zugeordneten kapazitiven Spannungsteilers angekoppelt ist.

In dieser dreiphasigen Realisierung besitzt die kapazitive Spannungsprüfvorrichtung folglich für jede der drei Phasen L1, L2, L3 die oben für den einphasigen Fall erläuterten Komponenten, Funktionalitäten und Eigenschaften, was hier keiner Wiederholung bedarf.

In entsprechenden Realisierungen weisen die mehradrigen Prüfverbindungsleitungen 4₁, 4₂, 4₃, wie im gezeigten Beispiel, separat voneinander je eine geerdete Schirmleitung 10₁, 10₂, 10₃ auf, die ihre beiden jeweiligen Leitungsadern A1₁, A2₁ etc. umgibt. Im gezeigten Beispiel sind die drei Schirmleitungen 10₁, 10₂, 10₃ elektrisch parallel an den ersten Eingang 11a des Spannungskomparators 11 angekoppelt. In alternativen Ausführungen kann für eine entsprechende phasengetrennte Leiterbruchüberwachung vorgesehen sein, dass die Schirmleitungen 10₁, 10₂, 10₃ getrennt voneinander an je einen eigenen Eingang des Spannungskomparators 11 angekoppelt sind bzw. für jede Schirmleitung 10₁, 10₂, 10₃ ein eigener Spannungskomparator 11 vorgesehen ist.

In weiteren alternativen Ausführungen der Erfindung erfolgt die Leiterbruchüberwachung ausreichen nur auf einer der Schirmleitungen 10₁, 10₂, 10₃, was für eine sichere Leiterbruchüberwachung in einem dreiphasigen System ausreichen kann, da eine Spannungsfreiheit in einem dreiphasigen System nur als solche erkannt werden darf, wenn alle Phasen spannungsfrei sind und ein dreiphasiger Leiterbruch von einer dreiphasigen Spannungsfreiheit auch durch Überwachung nur einer der Schirmleitungen 10₁, 10₂, 10₃ auf Leiterbruch unterschieden werden kann.

Die Auswerteeinheit 1 nimmt die Auswertung ihrer Eingangssignale zwecks Spannungsprüfung und Leiterbrucherkennung in einer an sich üblichen Weise vor, wie dies dem Fachmann geläufig ist und daher hier keiner näheren Beschreibung bedarf. Im gezeigten Beispiel besitzt die Auswerteeinheit 1 für jeden Messeingang 3 bzw. 3₁, 3₂, 3₃ je eine Spannungsprüfanzeige 15₁, 15₂, 15₃, z.B. als eine zu diesem Zweck an sich bekannte optische Anzeige. Außerdem weist sie eine Leiterbrucherkennungsanzeige 16 auf, um einen erkannten Leiterbruch anzuzeigen, z.B. als optisches Leuchtsignal.

Im gezeigten Beispiel sind die Auswerteeinheit 1 und der Spannungskomparator 11 Bestandteile eines auswerteseitig positionierbaren Spannungsprüfgerätes 13, das je nach Bedarf und Anwendungsfall weitere Komponenten herkömmlicher Art aufweisen kann. Es versteht sich, dass die Auswerteeinheit 1 bzw. deren einzelne Komponenten ebenso wie der Spannungskomparator 11 in beliebiger, dem Fachmann zur Erfüllung der von ihnen geforderten Funktionen an sich bekannter Weise in Hardware und/oder Software und dabei als getrennte Geräte mit jeweils eigenem Gerätegehäuse oder integriert oder teilintegriert mit einem oder mehreren gemeinsamen Gehäusen realisiert sein können.

Die Auswerteeinheit 1 kann, wie im gezeigten Beispiel, optional zusätzlich dafür eingerichtet sein, Teilentladungen z.B. im angekoppelten Niederspannungssystem anhand eines davon verursachten hochfrequenten Teilentladungssignals zu erkennen. Dazu weist die Auswerteeinheit 1 in diesem Fall eine Teilentladungserkennungseinheit 18 auf, die in einer beliebigen, dem Fachmann an sich bekannten Weise realisiert sein kann, und das hochfrequente Teilentladungssignal wird über die jeweilige Schirmleitung 10₁, 10₂, 10₃ an einer auswerteseitigen Auskoppelstelle 17, die sich z.B. im Spannungsprüfgerät 13 befinden kann, ausgekoppelt und der Teilentladungserkennungseinheit 18 zugeführt, wobei es durch einen Tiefpass 16 vor einer Ableitung zum Erdpotential U_{E} und durch einen Tiefpass 19 vor einer Ableitung zum Spannungskomparator 11 geschützt wird. Die Auswerteeinheit ist mit ihrer Teilentladungserkennungseinheit 18 in der Lage, eine im Niederspannungssystem vorhandene Teilentladung am zugeführten hochfrequenten Teilentladungssignal zu erkennen und ein zugehöriges Teilentladungserkennungssignal als Anzeigesignal abzugeben, z.B. als ein optisches Anzeigesignal. In alternativen Ausführungen kann die Auskoppelung an der Auskoppelstelle 17 und die Auswertung bzw. Anzeige des Teilentladungserkennungssignals durch die Teilentladungserkennungseinheit 18 auch phasenselektiv durch Auskoppelung des hochfrequenten Teilentladungssignals am zugehörigen Mittelabgriff 2₁, 2₂, 2₃ als entsprechende Ankoppelstelle erfolgen.

Wie die gezeigten und die weiteren oben erläuterten Ausführungsbeispiele deutlich machen, stellt die Erfindung eine kapazitive Spannungsprüfvorrichtung zur Verfügung, die eine vorteilhafte kapazitive Spannungsprüfung auch unter relativ beengten Platzverhältnissen, wie sie z.B. in Niederspannungsanlagen vorliegen, mit relativ geringem Aufwand ermöglicht.

Speziell ermöglicht die erfindungsgemäße kapazitive Spannungsprüfvorrichtung eine technisch wirtschaftliche und besonders raumsparende kapazitive Auskoppelung der Primärspannung, was es erlaubt, ohne eine Vorsicherung das Spannungssignal, d.h. die zu messende Spannung, beispielsweise in einer Niederspannungsanlage mit hinreichend großer Isolation auszukoppeln und der Spannungsprüfvorrichtung zur Verfügung zu stellen. Ein weiterer Vorteil der erfindungsgemäßen kapazitiven Spannungsprüfvorrichtung liegt darin, dass sie vergleichsweise kostensparend realiserbar ist und vergleichsweise einfach mit der zu messenden Primärspannung kontaktiert werden kann, z.B. durch direktes Anschließen des messstellenseitigen Messspannungsanschlusses der entsprechenden Leitungsader ihrer Prüfverbindungsleitung.

## Patentansprüche

1. Kapazitive Spannungsprüfvorrichtung, insbesondere zur Spannungsprüfung in Niederspannungsanlagen, mit
- einem kapazitiven Spannungsteiler, der einen Primärkondensator (C1) zur messstellenseitigen Ankopplung an eine zu messende Spannung (U_{M}) und einen Sekundärkondensator (C2) zur auswerteseitigen Ankopplung an ein Bezugspotential (U_{B}) umfasst, und
- einer Auswerteeinheit (1) mit einem an einen Mittelabgriff (2) des kapazitiven Spannungsteilers angekoppelten Messsignaleingang (3),
**gekennzeichnet durch**
- eine mehradrige Prüfverbindungsleitung (4) mit einer ersten Leitungsader (A1) und einer gegenüber der ersten Leitungsader (A1) elektrisch isolierten zweiten Leitungsader (A2), die zusammen den Primärkondensator (C1) bilden,
- wobei eine (A1) der beiden Leitungsadern (A1, A2) messstellenseitig einen Messspannungsanschluss (5) und auswerteseitig einen isolierten Anschluss (6) aufweist und die andere Leitungsader (A2) messstellenseitig einen isolierten Anschluss (7) und auswerteseitig einen Mittelabgriffanschluss (8) aufweist.

2. Kapazitive Spannungsprüfvorrichtung nach Anspruch 1, weiter **dadurch gekennzeichnet, dass** die beiden Leitungsadern (A1, A2) von nebeneinander in einer gemeinsamen Kabelleitung (9) verlaufenden Linienleitern oder von einer Kabelseele und einem Kabelschirm einer Koaxialleitung gebildet sind.

3. Kapazitive Spannungsprüfvorrichtung nach Anspruch 1 oder 2, weiter **dadurch gekennzeichnet, dass** die Prüfverbindungsleitung (4) eine die beiden Leitungsadern (A1, A2) umgebende und geerdete Schirmleitung (10) aufweist.

4. Kapazitive Spannungsprüfvorrichtung nach Anspruch 3, weiter **dadurch gekennzeichnet, dass** die Auswerteeinheit (1) einen Spannungskomparator (11) aufweist und die Schirmleitung (10) messstellenseitig einen Erdungsanschluss (12) aufweist und auswerteseitig mit dem Spannungskomparator (11) verbindbar ist, wobei die Auswerteeinheit (1) zur Leiterbruchüberwachung anhand eines Spannungsvergleichssignals (SV) des Spannungskomparators (11) eingerichtet ist

5. Kapazitive Spannungsprüfvorrichtung nach Anspruch 3 oder 4, weiter **dadurch gekennzeichnet, dass** die Auswerteeinheit (1) eine Teilentladungserkennungseinheit (18) aufweist und die Schirmleitung (10) messstellenseitig einen Erdungsanschluss (12) aufweist und mit ihrem Erdungsanschluss (12) über ein Tiefpassfilter (16) an ein Erdpotential (U_{E}) ankoppelbar ist und auswerteseitig mit der Teilentladungserkennungseinheit (18) verbindbar ist.

6. Kapazitive Spannungsprüfvorrichtung nach einem der Ansprüche 1 bis 5, weiter **dadurch gekennzeichnet, dass** sie zur dreiphasigen Spannungsprüfung eingerichtet ist und für jede Phase (L1, L2, L3) je einen kapazitiven Spannungsteiler, der einen zugehörigen Primärkondensator (C1₁, C1₂, C1₃) zur messstellenseitigen Ankopplung an eine zu messende Spannung (U_{M1}, U_{M2}, U_{M3}) der Phase und einen Sekundärkondensator (C2₁, C2₂, C2₃) zur auswerteseitigen Ankopplung an ein Bezugspotential (U_{B}) umfasst, und je eine mehradrige Prüfverbindungsleitung (4₁, 4₂, 4₃) mit einer ersten Leitungsader (A1₁, A1₂, A1₃) und einer gegenüber der ersten Leitungsader (A1₁, A1₂, A1₃) elektrisch isolierten zweiten Leitungsader (A2₁, A2₂, A2₃) aufweist, die zusammen den zugehörigen Primärkondensator (C1₁, C1₂, C1₃) bilden, wobei die Auswerteeinheit (1) für jede Phase je einen Messsignaleingang (3₁, 3₂, 3₃) beinhaltet, der an einen Mittelabgriff (2₁, 2₂, 2₃) des zugehörigen kapazitiven Spannungsteilers angekoppelt ist.

7. Kapazitive Spannungsprüfvorrichtung nach Anspruch 6, weiter **dadurch gekennzeichnet, dass** die mehradrigen Prüfverbindungsleitungen (4₁, 4₂, 4₃) separat voneinander je eine ihre beiden Leitungsadern (A1₁, A2₁; A1₂, A2₂; A1₃, A2₃) umgebende und geerdete Schirmleitung (10₁, 10₂, 10₃) aufweisen.

## Claims

1. Capacitive voltage testing device, preferably for voltage testing in low voltage systems, comprising
- a capacitive voltage divider comprising a primary capacitor (C1) for coupling on a measuring point side to a voltage (U_{M}) to be measured, and a secondary capacitor (C2) for coupling on an evaluation side to a reference potential (U_{B}), and
- an evaluation unit (1) with a measuring signal input (3) coupled to a center tap (2) of the capacitive voltage divider,
**characterized by**
- a multicore test connection line (4) having a first core (A1) and a second core (A2), electrically insulated from the first core (A1), which together form the primary capacitor (C1),
- wherein one core (A1) of the two cores (A1, A2) comprises a measurement voltage connection (5) on the measuring point side and an insulated connection (6) on the evaluation side, and the other core (A2) comprises an insulated connection (7) on the measuring point side and a center tap connection (8) on the evaluation side.

2. Capacitive voltage testing device according to claim 1, further **characterized in that** the two cores (A1, A2) are formed by line conductors extending adjacently to one another in a common cable line (9), or by a cable core and a cable shield of a coaxial line.

3. Capacitive voltage testing device according to claim 1 or 2, further **characterized in that** the test connection line (4) has a grounded shielding cable (10) surrounding the two cores (A1, A2).

4. Capacitive voltage testing device according to claim 3, further **characterized in that** the evaluation unit (1) comprises a voltage comparator (11) and **in that** the shielding cable (10) comprises a ground connection (12) on the measuring point side and is connectable to the voltage comparator (11) on the evaluation side, wherein the evaluation unit (1) is configured for conductor break monitoring based on a voltage comparison signal (SV) of the voltage comparator (11).

5. Capacitive voltage testing device according to claim 3 or 4, further **characterized in that** the evaluation unit (1) comprises a partial discharge detection unit (18) and **in that** the shielding cable (10) comprises a ground connection (12) on the measuring point side and is couplable with its ground connection (12) to a ground potential (U_{E}) via a low-pass filter (16) and is connectable to the partial discharge detection unit (18) on the evaluation side.

6. Capacitive voltage testing device according to any of claims 1 to 5, further **characterized in that** it is configured for three-phase voltage testing and comprises for each phase (L1, L2, L3) a respective capacitive voltage divider having an associated primary capacitor (C1₁, C1₂, C1₃) for coupling on the measuring point side to a phase voltage (U_{M1}, U_{M2}, U_{M3}) to be measured, and a secondary capacitor (C2₁, C2₂, C2₃) for coupling on the evaluation side to a reference potential (U_{B}), and **in that** it comprises for each phase a multicore test connection line (4₁, 4₂, 4₃), having a first core (A1₁, A1₂, A1₃) and a second core (A2₁, A2₂, A2₃), electrically insulated from the first core (A1₁, A1₂, A1₃), which together form the associated primary capacitor (C1₁, C1₂, C1₃), wherein the evaluation unit (1) comprises for each phase a measuring signal input (3₁, 3₂, 3₃) which is coupled to a center tap (2₁, 2₂, 2₃) of the associated capacitive voltage divider.

7. Capacitive voltage testing device according to claim 6, further **characterized in that** the multicore test connection lines (4₁, 4₂, 4₃) each have, separately from one another, a grounded shielding cable (10₁, 10₂, 10₃) surrounding their two cores (A1₁, A2₁; A1₂, A2₂; A1₃, A2₃) respectively.

## Revendications

1. Dispositif de contrôle de tension capacitif, notamment pour le contrôle de tension dans des installations basse tension, avec
- un diviseur de tension capacitif qui comprend un condensateur primaire (C1) pour le couplage du côté du point de mesure, à une tension (U_{M}) à mesurer et un condensateur secondaire (C2) pour le couplage, côté évaluation, à un potentiel de référence (U_{B}), et
- une unité d'évaluation (1) avec une entrée de signal de mesure (3) couplée à une prise médiane (2) du diviseur de tension capacitif,
caractérisé en
- une ligne de raccordement de contrôle (4) à plusieurs brins avec un premier brin de ligne (A1) et un second brin de ligne (A2) électriquement isolé du premier brin de ligne (A1) qui forment ensemble le condensateur primaire (C1),
- sachant qu'un (A1) des deux brins de ligne (A1, A2) présente, du côté du point de mesure, un raccord de tension de mesure (5) et, du côté évaluation, un raccord isolé (6) et que l'autre brin de ligne (A2) présente, du côté du point de mesure, un raccord isolé (7) et, du côté évaluation, un raccord de prise médiane (8).

2. Dispositif de contrôle de tension capacitif selon la revendication 1, caractérisé également en ce que les deux brins de ligne (A1, A2) sont formés par des conducteurs s'étendant côte à côte dans une ligne en câble (9) commune ou par une âme de câble et un blindage de câble d'une ligne coaxiale.

3. Dispositif de contrôle de tension capacitif selon la revendication 1 ou 2, caractérisé également en ce que la ligne de raccordement de contrôle (4) présente une ligne blindée (10) mise à la terre et entourant les deux brins de ligne (A1, A2).

4. Dispositif de contrôle de tension capacitif selon la revendication 3, caractérisé également en ce que l'unité d'évaluation (1) présente un comparateur de tension (11) et que la ligne blindée (10) présente, du côté du point de mesure, un raccord de mise à la terre (12) et est reliable, du côté évaluation, au comparateur de tension (11), sachant que l'unité d'évaluation (1) est configurée pour la surveillance de rupture de ligne au moyen d'un signal de comparaison de tension (SV) du comparateur de tension (11).

5. Dispositif de contrôle de tension capacitif selon la revendication 3 ou 4, caractérisé également en ce que l'unité d'évaluation (1) présente une unité de détection de décharge partielle (18) et que la ligne blindée (10) présente, du côté du point de mesure, un raccord de mise à la terre (12) et peut être couplée, au niveau de son raccord de mise à la terre (12) à un potentiel de terre (U_{E}) via un filtre passe-bas (16) et est reliable, côté évaluation, à l'unité de détection de décharge partielle (18).

6. Dispositif de contrôle de tension capacitif selon l'une des revendications 1 à 5, caractérisé également en ce qu'il est configuré pour le contrôle de tension triphasé et présente, pour chaque phase (L1, L2, L3), un diviseur de tension capacitif qui comprend un condensateur primaire correspondant (C1₁, C1₂, C1₃) pour le couplage, du côté du point de mesure, à une tension à mesurer (U_{M1}, U_{M2}, U_{M3}) de la phase et un condensateur secondaire (C2₁, C2₂, C2₃) pour le couplage, côté évaluation, à un potentiel de référence (U_{B}) et, pour chaque phase, une ligne de raccordement de contrôle à plusieurs brins (4₁, 4₂, 4₃) avec un premier brin de ligne (A1₁, A1₂, A1₃) et un second brin de ligne (A2₁, A2₂, A2₃) isolé électriquement du premier brin de ligne (A1₁, A1₂, A1₃) qui forment ensemble le condensateur primaire correspondant (C1₁, C1₂, C1₃), sachant que l'unité d'évaluation (1) comprend, pour chaque phase, une entrée de signal de mesure (3₁, 3₂, 3₃) qui est couplée à une prise médiane (2₁, 2₂, 2₃) du diviseur de tension capacitif correspondant.

7. Dispositif de contrôle de tension capacitif selon la revendication 6, caractérisé également en ce que les lignes de raccordement de contrôle (4₁, 4₂, 4₃) à plusieurs brins présentent, séparément l'une de l'autre, chacune une ligne blindée (10₁, 10₂, 10₃) mise à la terre et entourant les deux brins de ligne (A1₁, A2₁; A1₂, A2₂ ; A1₃, A2₃).
